# EUROPEAN PATENT APPLICATION

(11) **EP 4 756 447 A1**
(43) Date of publication of application: **10.06.2026**
(21) Application number: 25745262.3
(22) Date of filing: 24.01.2025
(51) Int. Cl.: G01R 31/374, G01R 31/396, G01R 31/382, G01R 19/165, G01R 19/10, B60L 58/10

(54) **APPARATUS AND METHOD FOR PROVIDING BATTERY INFORMATION**

(30) Priority: 26.01.2024 KR 20240012259
(71) Applicant: LG Energy Solution, Ltd., Seoul 07335 (KR)
(72) Inventor: CHOI, Soon-Hyung, Daejeon 34122 (KR); KIM, Dong-Hyun, Daejeon 34122 (KR); KIM, Young-Deok, Daejeon 34122 (KR)
(74) Representative: Goddar, Heinz J.
(86) International application number: PCT/KR2025/001542
(87) International publication number: WO 2025/159596

(57) **Abstract**

A battery information providing apparatus according to an embodiment of the present disclosure includes: a profile acquisition unit that acquires a differential profile based on a capacity and a voltage of a battery; and a control unit that determines a target cycle corresponding to the battery and a target C-rate (current-rate) corresponding to the differential profile, and correct the differential profile based on an overvoltage profile corresponding to the target cycle and the target C-rate, thereby generating a corrected profile.

## Description

### TECHNICAL FIELD

This application is based on and claims priority from Korean Patent Application No. 10-2024-0012259, filed on January 26, 2024, with the Korean Intellectual Property Office, the disclosure of which is incorporated herein in its entirety by reference.

The present disclosure relates to a battery information providing apparatus and method, more particularly, an apparatus and method for efficiently generating and providing information related to a battery.

### BACKGROUND

Recently, with the rapidly increasing demand for portable electronic products such as notebook computers, video cameras, and portable telephones, and the accelerating development of electric vehicles, energy storage batteries, robots, and satellites, researches on the high-performance batteries allowing repeated charging and discharging are actively underway.

Currently, commercially available batteries include, for example, nickel-cadmium batteries, nickel-hydrogen batteries, nickel-zinc batteries, and lithium batteries. Of these batteries, lithium batteries are gaining considerable attention due to their advantages including a substantially low memory effect to allow a high degree of freedom in charging and discharging, a very low self-discharging rate, and high energy density, as compared to nickel-based batteries.

While many studies are being conducted on the batteries focusing on the high-capacity and the high-density, it is also important to improve the lifespan and the safety of the batteries. In order to enhance the safety of batteries, a technology is necessary, which may accurately diagnose the current state of batteries.

In the related art, the state of a battery has been diagnosed by analyzing a battery profile representing a correspondence between the capacity and the voltage of the battery. For example, the capacity and the voltage are measured during a charging process of the battery, and the state of the battery is diagnosed by analyzing the battery profile representing the correspondence between the measured capacity and voltage. In another example, the state of the battery may be diagnosed based on the capacity and the voltage measured during a discharging process of the battery.

In order to more accurately diagnose the current state of the battery, a battery profile accurately reflecting the current state of the battery is needed. However, there is a problem of requiring low-rate charging and discharging at, for example, 0.05 C (C-rate) in order to acquire the battery profile. That is, since the related art requires the low-rate charging and discharging to diagnose the state of the battery, there is a limitation in diagnosing the state of the battery.

For example, when the battery is charged and discharged at a C-rate of 0.33 C or greater, an acquired battery profile includes an overvoltage, and therefore, the battery profile may not accurately reflect the current state of the battery due to the influence of the overvoltage. When the battery profile including the overvoltage is used, there is the problem that the state of the battery may not be accurately diagnosed, which requires the low-rate charging and discharging to accurately diagnose the state of the battery.

### SUMMARY

An embodiment of the present disclosure provides a battery information providing apparatus and method for quickly generating a profile used for diagnosing the state of a battery.

Various aspects of the present disclosure may be understood from the descriptions herein below, and may be more apparent with reference to embodiments of the present disclosure. Further, it may be readily recognized that various aspects of the present disclosure may be implemented by means and combinations thereof described in the claims.

A battery information providing apparatus according to an aspect of the present disclosure may include: a profile acquisition unit that acquires a differential profile based on a capacity and a voltage of a battery; and a control unit that determines a target cycle corresponding to the battery and a target C-rate (current-rate) corresponding to the differential profile, and corrects the differential profile based on an overvoltage profile corresponding to the target cycle and the target C-rate, thereby generating a corrected profile.

The control unit may be configured to calculate a difference between the differential profile and the overvoltage profile to generate the corrected profile.

The overvoltage profile may be pre-stored for each of a plurality of charging and discharging cycles and a plurality of C-rates.

The control unit may be configured to select an overvoltage profile corresponding to the target cycle and the target C-rate from a plurality of pre-stored overvoltage profiles.

The overvoltage profile may be preset based on a reference differential profile of a first reference battery for the target cycle and a reference C-rate and a target differential profile of a second reference battery for the target cycle and the target C-rate.

Based on a first target differential profile corresponding to a first target cycle and a second target differential profile corresponding to a second target cycle, a plurality of overvoltage profiles may be set to correspond to a plurality of cycles, respectively, included in the first target cycle and the second target cycle.

The overvoltage profile may be set by interpolating a difference between the first target differential profile and the second target differential profile to be proportional to each of the plurality of cycles.

The overvoltage profile may be preset to represent a difference between the reference differential profile and the target differential profile.

The target C-rate may be set to be greater than the reference C-rate.

The profile acquisition unit may be configured to acquire a first differential profile representing a correspondence between the capacity and a differential voltage.

The control unit may be configured to correct the first differential profile based on a first overvoltage profile representing the correspondence between the capacity and the differential voltage.

The profile acquisition unit may be configured to acquire a second differential profile representing a correspondence between the voltage and a differential capacity.

The control unit may be configured to correct the second differential profile based on a second overvoltage profile representing the correspondence between the voltage and the differential capacity.

The control unit may be configured to output the corrected profile to an outside, to provide information about the battery.

A battery pack according to another aspect of the present disclosure may include the battery information providing apparatus according to an aspect of the present disclosure.

A vehicle according to yet another aspect of the present disclosure may include the battery information providing apparatus according to an aspect of the present disclosure.

A battery information providing method according to still yet another aspect of the present disclosure may include: a profile acquisition step of acquiring a differential profile based on a capacity and a voltage of a battery; a target determination step of determining a target cycle corresponding to the battery and a target C-rate (current-rate) corresponding to the differential profile; and a corrected profile generation step of correcting the differential profile based on an overvoltage profile corresponding to the target cycle and the target C-rate, thereby generating a corrected profile.

A non-transitory computer-readable storage medium according to still yet another aspect of the present disclosure may store therein a program for performing a battery information providing method including: a profile acquisition step of acquiring a differential profile based on a capacity and a voltage of a battery; a target determination step of determining a target cycle corresponding to the battery and a target C-rate (current-rate) corresponding to the differential profile; and a corrected profile generation step of correcting the differential profile based on an overvoltage profile corresponding to the target cycle and the target C-rate, thereby generating a corrected profile.

According to an aspect of the present disclosure, a battery information providing apparatus may relatively quickly generate a corrected profile used for diagnosing the state of a battery, so that the total time required to diagnose the state of the battery may be reduced.

The effects of the present disclosure are not limited to those described above, and other effects that are not described herein may clearly be understood to those skilled in the art from the descriptions in the claims.

### BRIEF DESCRIPTION OF THE DRAWINGS

Since the drawings attached herewith serve to facilitate the understanding of the technical idea of the present disclosure in conjunction with the detailed description of the invention herein below, the present disclosure should not be construed as being limited to the matters illustrated in the drawings.
FIG. 1 is a view schematically illustrating a battery information providing apparatus according to an embodiment of the present disclosure.
FIG. 2 is a view schematically illustrating a battery profile according to an embodiment of the present disclosure.
FIG. 3 is a view schematically illustrating a first differential profile according to an embodiment of the present disclosure.
FIG. 4 is a view schematically illustrating a second differential profile according to an embodiment of the present disclosure.
FIG. 5 is a view schematically illustrating an overvoltage profile according to an embodiment of the present disclosure.
FIG. 6 is a view schematically illustrating a corrected profile according to an embodiment of the present disclosure.
FIG. 7 is a view schematically illustrating a plurality of overvoltage profiles according to an embodiment of the present disclosure.
FIG. 8 is a view schematically illustrating a battery pack according to another embodiment of the present disclosure.
FIG. 9 is a view schematically illustrating a vehicle according to yet another embodiment of the present disclosure.
FIG. 10 is a view schematically illustrating a battery information providing method according to still yet another embodiment of the present disclosure.

### DETAILED DESCRIPTION

Words and terms used in the detailed description and the claims herein should not be interpreted to be limited to their usual or dictionary meanings, but should be interpreted to have meanings and concepts that correspond to the technical idea of the present disclosure in compliance with the principle that inventors may appropriately define terms and concepts for the purpose of best describing the present disclosure.

Accordingly, it can be appreciated that the embodiments described herein and the configurations illustrated in the drawings are merely examples of the present disclosure, which do not exhaustively represent the technical idea of the present disclosure, and various equivalents and modifications may be made to substitute the present disclosure at the time of filing the present disclosure.

When describing the present disclosure, detailed description of related known configurations or functions may be omitted if determined to obscure the gist of the present disclosure.

Terms with ordinal numbers such as first, second and so on may be used to discriminate one of various components from another, but should not be interpreted as limiting the components.

Throughout the descriptions herein, when a certain part "includes" a specific component, this description does not indicate that the certain part excludes other components, but indicates that the certain part may further include other components, unless otherwise defined.

Further, throughout the descriptions herein, when two components are "connected" to each other, this description indicates not only that the two components are "directly connected" to each other, but also that the two components are "indirectly connected" to each other via another component.

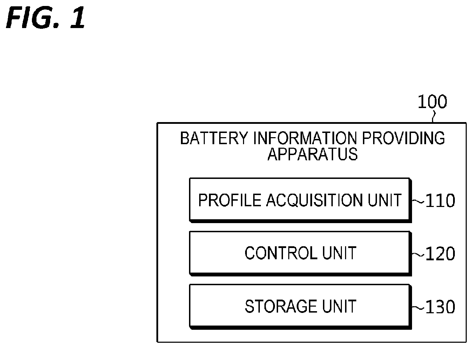

FIG. 1 is a view schematically illustrating a battery information providing apparatus 100 according to an embodiment of the present disclosure.

Referring to FIG. 1, the battery information providing apparatus 100 may include a profile acquisition unit 110, a control unit 120, and a storage unit 130.

A battery may indicate a single isolated cell that is physically separable and has a negative electrode terminal and a positive electrode terminal. For example, a lithium-ion battery or a lithium polymer battery may be considered as the battery. The type of battery may be a cylindrical type, a prismatic type, or a pouch type. Further, the battery may indicate a battery bank, a battery module, or a battery pack, in which a plurality of cells is connected to each other in series and/or in parallel. Herein below, for the convenience of description, it is assumed that the battery indicates a single isolated cell.

The profile acquisition unit 110 may be configured to acquire a differential profile based on the capacity and the voltage of the battery.

For example, a battery profile BP is a profile representing a correspondence between the voltage (V) and the capacity (Q) of a battery when the battery is charged from a preset charging start SOC or 0 % to a preset charging termination SOC or 100 %. In another example, the battery profile BP may represent a correspondence between the voltage (V) and the capacity (Q) of a battery when the battery is discharged from a preset discharging start SOC or 100 % to a preset discharging termination SOC or 0 %.

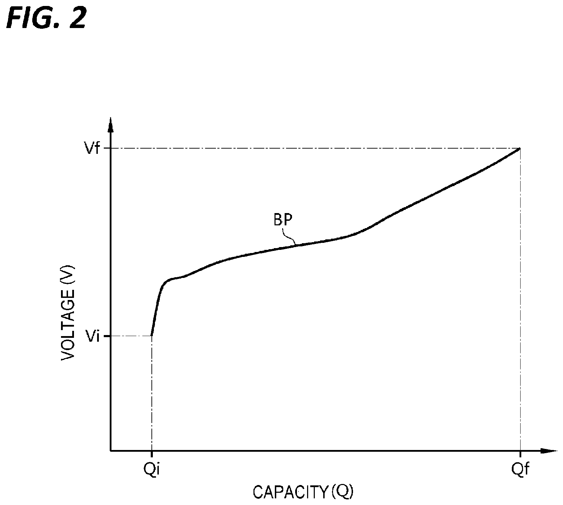

FIG. 2 is a view schematically illustrating the battery profile BP according to an embodiment of the present disclosure. The battery profile BP may be represented as an X-Y graph in which the X axis is set as the capacity (Q), and the Y axis is set as the voltage (V). The voltage range of the battery is Vi to Vf, and the capacity range of the battery is Qi to Qf.

Then, when the battery profile BP is differentiated with respect to the capacity, a differential profile may be generated, which represents a correspondence between the differential voltage (dV/dQ) and the capacity (Q). The differential voltage is a differential value of the voltage with respect to the capacity, which is a value obtained by differentiating the voltage with respect to the capacity. Hereinafter, the differential profile generated by differentiating the voltage with respect to the capacity will be referred to as a first differential profile DP1.

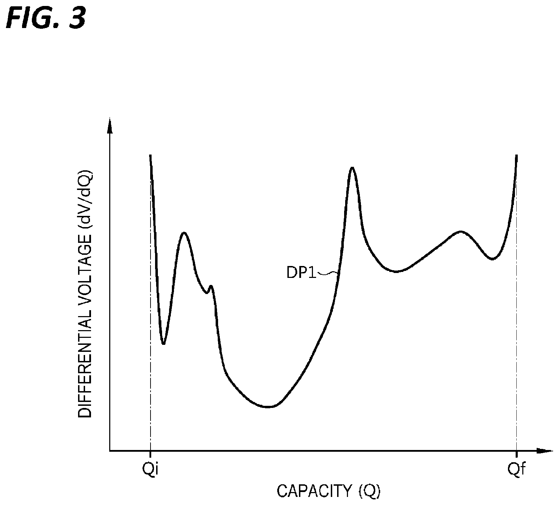

FIG. 3 is a view schematically illustrating the first differential profile DP1 according to an embodiment of the present disclosure. The first differential profile DP1 may be represented as an X-Y graph in which the X axis is set as the capacity (Q), and the Y axis is set as the differential voltage (dV/dQ).

When the battery profile BP is differentiated with respect to the voltage, a differential profile may be generated, which represents a correspondence between the differential capacity (dQ/dV) and the voltage (V). Here, the differential capacity is a differentiated value of the capacity with respect to the voltage, which is a value obtained by differentiating the capacity with respect to the voltage. Hereinafter, the differential profile generated by differentiating the capacity with respect to the voltage will be referred to as a second differential profile DP2.

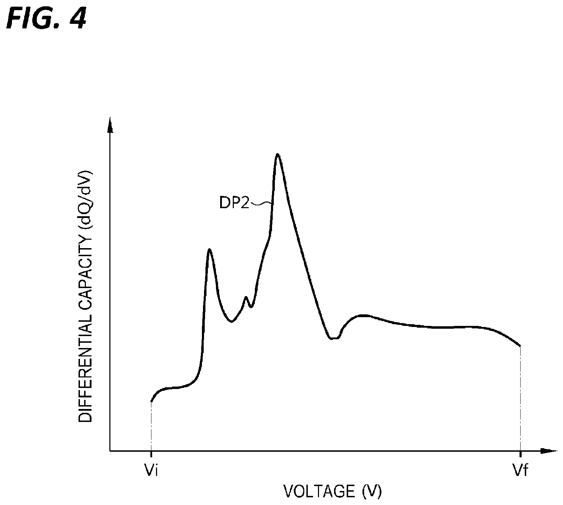

FIG. 4 is a view schematically illustrating the second differential profile DP2 according to an embodiment of the present disclosure. The second differential profile DP2 may be represented as an X-Y graph in which the X axis is set as the voltage (V), and the Y axis is set as the differential capacity (dQ/dV).

For example, the C-rate of the charging or discharging for generating the battery profile BP is not particularly limited. In order to acquire more accurate battery profile BP and differential profile, the battery may be charged or discharged at a low rate. For example, the battery profile BP may be generated during the process of charging or discharging the battery at a low rate such as 0.05 C.

For example, the profile acquisition unit 110 may directly receive the differential profile of the battery from the outside. For example, the profile acquisition unit 110 may acquire the differential profile by being connected to the outside via a wired and/or wireless network to receive the differential profile.

In another example, the profile acquisition unit 110 may directly receive the battery profile BP of the battery from the outside. Then, the profile acquisition unit 110 may generate the differential profile based on the received battery profile BP. For example, the profile acquisition unit 110 may be connected to the outside via a wired and/or wireless network to receive the battery profile BP, and directly generate the differential profile from the received battery profile BP, to acquire the differential profile.

In another example, the profile acquisition unit 110 may generate battery information about the voltage and the capacity of the battery. Then, the profile acquisition unit 110 may generate the battery profile BP based on the received battery information, and may generate the differential profile based on the generated battery profile BP. The profile acquisition unit 110 may acquire the differential profile by directly generating the differential profile based on the received battery information.

The profile acquisition unit 110 may be connected to the control unit 120 for a communication. For example, the profile acquisition unit 110 may be connected to the control unit 120 in the wired or wireless manner. The profile acquisition unit 110 may transmit the acquired differential profile to the control unit 120.

The control unit 120 may be configured to determine a target cycle corresponding to the battery and a target C-rate corresponding to the differential profile.

Further, the control unit 120 may acquire information about the target cycle and the target C-rate together with the differential profile from the profile acquisition unit 110.

For example, when the charging and discharging cycle of the battery is a 30th cycle, the target cycle corresponding to the battery may be the 30th cycle. The control unit 120 may receive the differential profile and information about the 30th cycle from the profile acquisition unit 110. Then, the control unit 120 may determine the 30th cycle corresponding to the battery to be the target cycle.

For example, when the battery is charged at 0.33 C, the target C-rate corresponding to the differential profile may be 0.33 C. The control unit 120 may receive the differential profile and information about 0.33 C from the profile acquisition unit 110. Then, the control unit 120 may determine 0.33 C corresponding to the differential profile to be the target C-rate.

The control unit 120 may be configured to correct the differential profile based on an overvoltage profile OP corresponding to the target cycle and the target C-rate, thereby generating a corrected profile CP.

The overvoltage profile OP may be preset to represent an overvoltage portion included in the differential profile. For example, the overvoltage profile OP may be preset based on a reference differential profile of a first reference battery for the target cycle and a reference C-rate and a target differential profile of a second reference battery for the target cycle and the target C-rate. The target C-rate may be set to be greater than the reference C-rate. According to an embodiment, the overvoltage profile OP may be preset to represent a difference between the reference differential profile and the target differential profile.

For example, when the target cycle is the 30th cycle, the reference C-rate is 0.05 C, the target C-rate is 0.33 C, and the first reference battery is charged (or discharged) at 0.05 C during the 30th cycle, a reference battery profile for the reference C-rate may be acquired, and the reference differential profile may be acquired based on the reference battery profile. Then, when the second reference battery is charged (or discharged) at 0.33 C during the 30th cycle, a target battery profile for the target C-rate may be acquired, and the target differential profile may be acquired based on the target battery profile. According to the difference between the reference differential profile and the target differential profile corresponding to the same charging and discharging cycle, the overvoltage profile OP corresponding to the 30th cycle and the C-rate of 0.33 C may be generated. When the battery is charged and discharged at the target C-rate greater than the reference C-rate, the measured voltage of the battery may include an overvoltage. Thus, the control unit 120 may remove the reference differential profile based on the reference C-rate from the target differential profile based on the target C-rate, to generate the overvoltage profile OP.

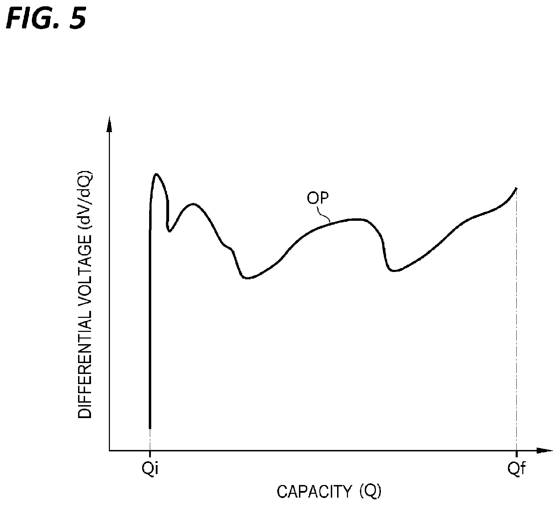

FIG. 5 is a view schematically illustrating the overvoltage profile OP according to an embodiment of the present disclosure. FIG. 5 illustrates the overvoltage profile OP corresponding to the first differential profile DP1.

The overvoltage profile OP according to the embodiment of FIG. 5 may be represented as an X-Y graph in which the X axis is set as the capacity, and the Y axis is set as the differential voltage. When the differential profile acquired by the profile acquisition unit 110 is the first differential profile DP1, the overvoltage profile OP may represent the correspondence between the capacity and the differential voltage.

The overvoltage profile OP corresponding to the second differential profile DP2 may be represented as an X-Y graph in which the X axis is set as the voltage, and the Y axis is set as the differential capacity. When the differential profile acquired by the profile acquisition unit 110 is the second differential profile DP2, the overvoltage profile OP may represent the correspondence between the voltage and the differential capacity.

Then, the control unit 120 may be configured to select the overvoltage profile OP corresponding to the target cycle and the target C-rate from a plurality of pre-stored overvoltage profiles OP.

The overvoltage profile OP may be pre-stored for each of a plurality of charging and discharging cycles and a plurality of C-rates.

A plurality of overvoltage profiles OP may be provided, and the charging and discharging cycles and the C-rates corresponding to the plurality of overvoltage profiles OP, respectively, may be different from each other. For example, based on unit charging and discharging cycles and unit C-rates, overvoltage profiles OP corresponding to the C-rates, respectively, may be stored in advance.

The control unit 120 may be configured to calculate a difference between the differential profile and the overvoltage profile OP to generate the corrected profile CP.

For example, the control unit 120 may generate the corrected profile CP by calculating the difference between the differential profile and the overvoltage profile OP in the same way that the overvoltage profile OP is generated according to the difference between the reference differential profile and the target differential profile.

For example, when the differential profile is the first differential profile DP1, the control unit 120 may calculate a differential voltage difference for each capacity between the first differential profile DP1 and the overvoltage profile OP to generate the corrected profile CP.

In another embodiment, when the differential profile is the second differential profile DP2, the control unit 120 may calculate a differential capacity difference for each voltage between the second differential profile DP2 and the overvoltage profile OP to generate the corrected profile CP.

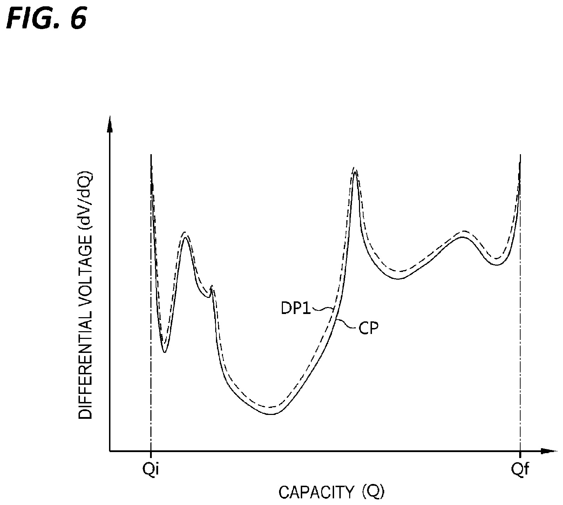

FIG. 6 is a view schematically illustrating the corrected profile CP according to an embodiment of the present disclosure. In the embodiments of FIGS. 5 and 6, the corrected profile CP may be generated according to the differential voltage difference for the capacity between the first differential profile DP1 and the overvoltage profile OP. The control unit 120 may calculate the difference between the first differential profile DP1 and the overvoltage profile OP, to generate the corrected profile CP in which the overvoltage portion included in the first differential profile DP1 is removed.

According to an embodiment of the present disclosure, it is not enforced to charge and discharge the battery at the low C-rate (*e.g.,* 0.05 C) for the purpose of acquiring an accurate differential profile, so that the corrected profile CP in which the overvoltage is removed may be acquired quickly. Further, since the corrected profile CP is used for diagnosing the state of the battery, it is advantageous in that the battery information providing apparatus 100 may quickly generate and provide the profile used for diagnosing the state of the battery.

For example, when the low-rate charging and discharging at 0.05 C are enforced to acquire the battery profile BP, it may take about 20 hours merely to acquire the battery profile BP. Further, additional time may be required to perform a process of converting the acquired battery profile BP into the differential profile and diagnosing the state of the battery according to the differential profile. When the charging and discharging are performed at the low C-rate as described above, a significant amount of time is required to perform the process of acquiring the battery profile BP, which makes it difficult to quickly diagnose the state of the battery.

When the battery is charged and discharged at the C-rate of 0.33 C as in an embodiment of the present disclosure, the battery profile BP may be acquired in about 3 hours. According to an embodiment of the present disclosure, the time required to acquire the battery profile BP may be reduced, as compared to when the charging and discharging are performed at the low C-rate such as 0.05 C.

The battery profile BP acquired according to an embodiment of the present disclosure includes an overvoltage that corresponds to noise. By calculating the difference between the differential profile and the overvoltage profile OP, the battery information providing apparatus 100 may quickly remove noise included in the differential profile. Thus, even further taking into account the time required during the process of generating the corrected profile CP, the battery information providing apparatus 100 according to an embodiment of the present disclosure may has the advantage of diagnosing the state of the battery relatively very quickly, as compared to the method that enforces the low-rate charging and discharging.

The profile acquisition unit 110 and the control unit 120 provided in the battery information providing apparatus 100 may selectively include, for example, a processor, an application-specific integrated circuit (ASIC), other chipsets, logic circuits, registers, a communication modem, and a data processing device, which are well-known in the art, in order to execute various control logics performed in the present disclosure. When the control logics are implemented by software, the profile acquisition unit 110 and the control unit 120 may be implemented as a set of program modules. In this case, the program modules may be stored in a memory, and executable by the profile acquisition unit 110 and the control unit 120. The memory may be provided inside or outside the profile acquisition unit 110 and the control unit 120, and may be connected to the profile acquisition unit 110 and the control unit 120 by various well-known means.

The battery information providing apparatus 100 may further include the storage unit 130. The storage unit 130 may store, for example, data or programs necessary when each component of the battery information providing apparatus 100 performs the operation and function thereof, or data generated during the performance of the operation and function. The storage unit 130 is not particularly limited in type, and may be a well-known information storage means capable of recording, erasing, updating, and reading data. For example, the information storage means may include, for example, a random access memory (RAM), a flash memory, a read-only memory (ROM), an electronically erasable programmable read-only memory (EEPROM), and a register. Further, the storage unit 130 may store program codes, in which processes executable by the profile acquisition unit 110 and the control unit 120 are defined.

The storage unit 130 may store the battery profile BP, the differential profiles DP1 and DP2, the overvoltage profile OP, and the corrected profile CP.

In an embodiment, the profile acquisition unit 110 may be configured to acquire the first differential profile DP1 representing the correspondence between the capacity and the differential voltage. The control unit 120 may be configured to correct the first differential profile DP1 based on the first overvoltage profile OP representing the correspondence between the capacity and the differential voltage.

In another embodiment, the profile acquisition unit 110 may be configured to acquire the second differential profile DP2 representing the correspondence between the voltage and the differential capacity. The control unit 120 may be configured to correct the second differential profile DP2 based on the second overvoltage profile representing the correspondence between the voltage and the differential capacity.

Since the difference between the differential profile and the overvoltage profile OP should be calculated in order to generate the corrected profile CP, the differential profile and the overvoltage profile OP may have the same format.

When the differential profile represents the correspondence between the capacity and the differential voltage, the overvoltage profile OP may also represent the correspondence between the capacity and the differential voltage. When the differential profile represents the correspondence between the voltage and the differential capacity, the overvoltage profile OP may also represent the correspondence between the voltage and the differential capacity.

For example, referring to FIGS. 3, 5, and 6, the first differential profile DP1 and the overvoltage profile OP represent the correspondence between the capacity and the differential voltage. Thus, the control unit 120 may calculate the differential voltage difference for each capacity between the first differential profile DP1 and the overvoltage profile OP, to generate the corrected profile CP.

Based on a first target differential profile corresponding to a first target cycle and a second target differential profile corresponding to a second target cycle, a plurality of overvoltage profiles OP may be set to correspond to a plurality of charging and discharging cycles, respectively, included in the first target cycle and the second target cycle.

The overvoltage profile OP may be set by interpolating the difference between the first target differential profile and the second target differential profile to be proportional to each of the plurality of charging and discharging cycles.

An overvoltage profile OP for a charging and discharging cycle and a C-rate that are not acquired experimentally may be acquired and stored through an interpolation or extrapolation between similar overvoltage profiles OP. For example, the control unit 120 may generate overvoltage profiles OP for various charging and discharging cycles and C-rates through the interpolation or extrapolation, in addition to the pre-stored overvoltage profiles OP, and store the generated overvoltage profiles OP in the storage unit 130.

For example, when a first overvoltage profile OP corresponding to a 10th cycle and the C-rate of 1 C and a second overvoltage profile OP corresponding to the 10th cycle and the C-rate of 1.2 C are stored in advance, an overvoltage profile corresponding to the 10th cycle and the C-rate of 1.1 C may be further acquired based on the difference between the first and second overvoltage profiles OP.

In another example, when the first overvoltage profile OP corresponding to the 10th cycle and the C-rate of 1 C and a third overvoltage profile OP corresponding to the 10th cycle and the C-rate of 1 C are stored in advance, an overvoltage profile OP corresponding to a 11th cycle and the C-rate of 1 C may be further acquired based on the difference between the first and third overvoltage profiles OP.

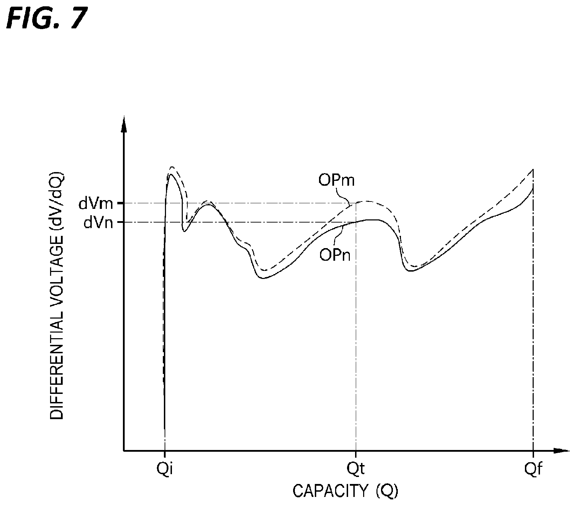

FIG. 7 is a view schematically illustrating the plurality of overvoltage profiles according to an embodiment of the present disclosure. In the embodiment of FIG. 7, the target C-rates corresponding to an n-th overvoltage profile and an m-th overvoltage profile are the same, "n" is a natural number equal to or more than 1, and "m" is a natural number equal to or more than n+2.

In the embodiment of FIG. 7, when an n-th overvoltage profile OPn corresponds to an n-th cycle, an m-th overvoltage profile OPm corresponds to an m-th cycle, and overvoltage profiles corresponding to n+1-th to m-1-th cycles are not stored, the overvoltage profiles OP corresponding to the n+1-th to m-1-th cycles may be generated and stored in proportion to the difference between the n-th overvoltage profile OPn and the m-th overvoltage profile OPm. For example, the differential voltage corresponding to the capacity Qt of the n-th overvoltage profile OPn is dVn, and the differential voltage corresponding to the capacity Qt of the m-th overvoltage profile OPm is dVm. The differential voltage difference between dVm and dVn (dVm-dVn) may be interpolated to be proportional to each of the n+1-th to m-1-th cycles. For example, the differential voltage corresponding to the capacity Qt of a k-th cycle ("k" is a natural number of n+1 or more and m-1 or less) may be calculated according to the arithmetic formula "dVn+(dVm-dVn)÷(m-n)×(k-n)." The differential voltage difference (dVm-dVn) may be interpolated to be proportional to the k-th cycle.

According to an embodiment, when the charging and discharging cycle corresponding to a first overvoltage profile OP is a 1st cycle, and the differential voltage corresponding to a first capacity is 11, and when the charging and discharging cycle corresponding to a tenth overvoltage profile OP is a 10th cycle, and the differential voltage corresponding to a first capacity is 20, the differential voltage corresponding to a first capacity of a fifth overvoltage profile OP corresponding to a 5th cycle is 15. In the arithmetic formula above, when 11 is substituted into dVn, 20 is substituted into dVm, 1 is substituted into "n," 10 is substituted into "m," and 5 is substituted into "k," 15 is obtained according to the arithmetic formula "11+(20-11)÷(10-1)×(5-1)."

Since a plurality of overvoltage profiles OP is set to correspond to a plurality of charging and discharging cycles and a plurality of C-rates, the overvoltage profile OP corresponding to the target cycle and the target C-rate may be quickly determined.

The control unit 120 may be configured to output the corrected profile CP to the outside to provide information about the battery.

The control unit 120 may be connected to an external device capable of diagnosing the state of the battery based on the corrected profile CP, via a wired or wireless network for a communication. The control unit 120 may transmit the corrected profile CP to an external device though the wired and/or wireless communication. For example, the external device is not particularly limited as long as it is a device including a diagnosing device or server and capable of analyzing the corrected profile CP to diagnose the state of the battery.

Since the corrected profile CP is a profile representing the current state of the battery, the state of the battery may be diagnosed based on the behavior of peaks included in the corrected profile CP. A peak refers to a maximum point or a minimum point of the corrected profile CP. In a case where the state of the battery is diagnosed based on a differential profile including an overvoltage, the state of the battery may not be accurately diagnosed due to the influence of the overvoltage. Since the battery information providing apparatus 100 generates and provides the corrected profile CP in which the overvoltage included in the differential profile is removed, the state of the battery may be relatively accurately diagnosed based on the corrected profile CP. The battery information providing apparatus 100 quickly generates the corrected profile CP used for diagnosing the state of the battery, so that the total time required to diagnose the state of the battery may be reduced.

The battery information providing apparatus 100 according to the present disclosure may be applied to a battery management system (BMS). For example, a BMS according to the present disclosure may include the battery information providing apparatus 100 described above. In this configuration, at least a portion of the respective components of the battery information providing apparatus 100 may be implemented by complementing or adding functions of components included in well-known BMSs. For example, the profile acquisition unit 110, the control unit 120, and the storage unit 130 of the battery information providing apparatus 100 may be implemented as components of the BMS.

Further, the battery information providing apparatus 100 according to the present disclosure may be provided in a battery pack. A battery pack according to the present disclosure may include the battery information providing apparatus 100 described above and one or more battery cells. The battery pack may further include, for example, electrical components (*e.g*., relays and fuses) and a case.

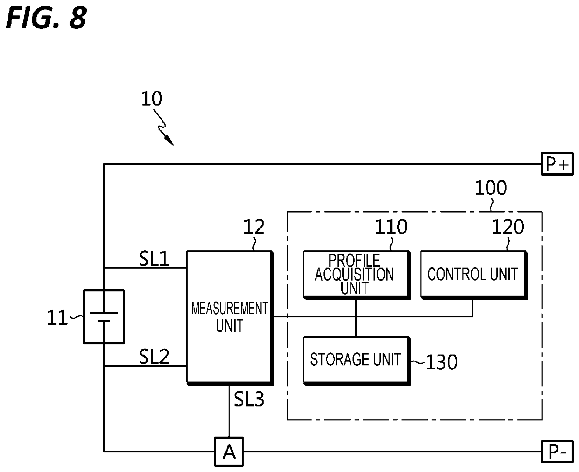

FIG. 8 is a view schematically illustrating a battery pack 10 according to another embodiment of the present disclosure.

The positive terminal of the battery 11 may be connected to the positive terminal P+ of the battery pack 10, and the negative terminal of the battery 11 may be connected to the negative terminal P- of the battery pack 10.

The measurement unit 12 may be connected to a first sensing line SL1, a second sensing line SL2, and a third sensing line SL3. The measurement unit 12 may be connected to the positive terminal of the battery 11 via the first sensing line SL1, and may be connected to the negative terminal of the battery 11 via the second sensing line SL2. The measurement unit 12 may measure the voltage of the battery 11 based on the voltage measured in each of the first sensing line SL1 and the second sensing line SL2.

The measuring unit 12 may be connected to a current measuring unit A via the third sensing line SL3. For example, the current measuring unit A may be an ammeter or a shunt resistor capable of measuring the charging current and the discharging current of the battery 11. The measurement unit 12 may measure the charging current of the battery 11 through the third sensing line SL3 to calculate a charging amount. Further, the measurement unit 12 may measure the discharging current of the battery 11 through the third sensing line SL3 to calculate a discharging amount.

For example, the profile acquisition unit 110 may receive battery information about the voltage and the current of the battery from the measurement unit 12. Then, the profile acquisition unit 110 may generate the battery profile and the differential profile based on the battery information.

In another example, the profile acquisition unit 110 may receive the battery profile BP from the measurement unit 12. Then, the profile acquisition unit 110 may generate the differential profile based on the battery profile BP.

In yet another example, the profile acquisition unit 110 may receive the differential profile from the measurement unit 12.

An external device may be connected to the positive terminal P+ and the negative terminal P- of the battery pack 10. For example, the external device may be a charging device or a load. The positive electrode terminal of the battery 11, the positive electrode terminal P+ of the battery pack 10, the external device, the negative electrode terminal P- of the battery pack 10, and the negative electrode terminal of the battery 11 may be electrically connected to each other.

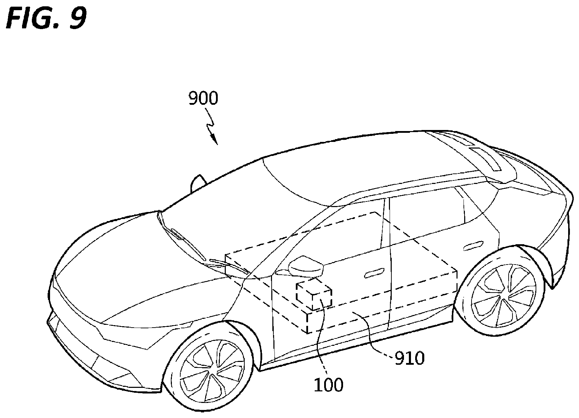

FIG. 9 is a view schematically illustrating a vehicle according to yet another embodiment of the present disclosure.

Referring to FIG. 9, the battery pack according to an embodiment of the present disclosure may be included in a vehicle 900 such as an electric vehicle (EV) or a hybrid vehicle (HV). A battery pack 910 may supply a power to a motor via an inverter provided in the vehicle 900, to drive the vehicle 900. Here, the battery pack 910 may include the battery information providing apparatus 100. For example, the vehicle 900 may include the battery information providing apparatus 100. In this case, the battery information providing apparatus 100 may be an on-board apparatus included in the vehicle 900.

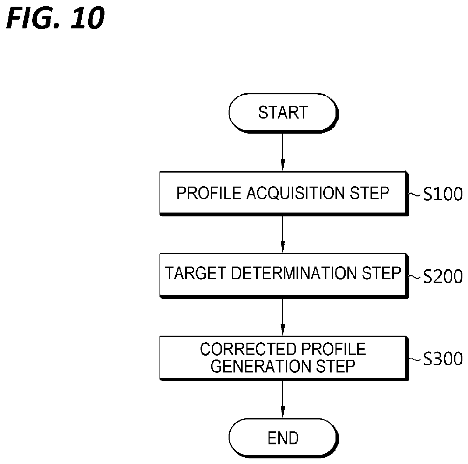

FIG. 10 is a view schematically illustrating a battery information providing method according to still yet another embodiment of the present disclosure.

Referring to FIG. 10, the battery information providing method may include a profile acquisition step S100, a target determination step S200, and a corrected profile (CP) generation step S300.

Each step of the battery information providing method may be performed by the battery information providing apparatus 100.

The profile acquisition step S100 is a step of acquiring the differential profile based on the capacity and the voltage of the battery, and may be performed by the profile acquisition unit 110.

For example, the profile acquisition unit 110 may directly receive the differential profile of the battery from the outside. For example, the profile acquisition unit 110 may acquire the differential profile by being connected to the outside via a wired and/or wireless network to receive the differential profile.

In another example, the profile acquisition unit 110 may directly receive the battery profile BP of the battery from the outside. Then, the profile acquisition unit 110 may generate the differential profile based on the received battery profile BP. The profile acquisition unit 110 may be connected to the outside via a wired and/or wireless network to receive the battery profile BP, and directly generate the differential profile from the received battery profile BP, to acquire the differential profile.

In another example, the profile acquisition unit 110 may generate battery information about the voltage and the capacity of the battery. Then, the profile acquisition unit 110 may generate the battery profile BP based on the received battery information, and may generate the differential profile based on the generated battery profile BP. The profile acquisition unit 110 may acquire the differential profile by directly generating the differential profile based on the received battery information.

The target determination step S200 is a step of determining the target cycle corresponding to the battery and the target C-rate corresponding to the differential profile, and may be performed by the control unit 120.

For example, the control unit 120 may acquire information about the differential profile, the charging and discharging cycle, and the target C-rate from the profile acquisition unit 110. Then, the control unit 120 may determine the received charging and discharging cycle to be the target cycle, and determine the received C-rate to be the target C-rate.

The corrected profile (CP) generation step S300 is a step of correcting the differential profile based on the overvoltage profile OP corresponding to the target cycle and the target C-rate to generate the corrected profile CP, and may be performed by the control unit 120.

Then, the control unit 120 may be configured to select the overvoltage profile OP corresponding to the target cycle and the target C-rate from a plurality of pre-stored overvoltage profiles OP. The control unit 120 may be configured to calculate the difference between the differential profile and the overvoltage profile OP to generate the corrected profile CP.

For example, when the differential profile is the first differential profile DP1, the control unit 120 may calculate the differential voltage difference for each capacity between the first differential profile DP1 and the overvoltage profile OP to generate the corrected profile CP.

In another embodiment, when the differential profile is the second differential profile DP2, the control unit 120 may calculate the differential capacity difference for each voltage between the second differential profile DP2 and the overvoltage profile OP to generate the corrected profile CP.

The embodiments of the present disclosure described above are not only implemented by an apparatus and method, but may also be implemented by programs implementing functions corresponding to the components of the embodiments of the present disclosure or a recording medium that stores the programs. This implementation may readily be achieved by one skilled in the art to which the present disclosure belongs, from the descriptions of the embodiments above.

While the present disclosure has been described using limited embodiments and drawings, the present disclosure is not limited thereto, and it may be appreciated that various modifications and changes may be made by those having ordinary skill in the art of the present disclosure within the technical idea of the present disclosure and the equitable scope of the claims set forth below.

Further, since various substitutions, modifications, and changes may be made by those having ordinary skill in the art of the present disclosure within the scope that does not depart from the technical idea of the present disclosure, the present disclosure described above is not limited by the foregoing embodiments and the accompanying drawings, but all or portions of the embodiments may be selectively combined to make various modifications.

### (Description of Symbols)

- 10:: battery pack
- 11:: battery
- 12:: measurement unit
- 100:: battery information providing apparatus
- 110:: profile acquisition unit
- 120:: control unit
- 130:: storage unit
- 800:: vehicle
- 810:: battery pack

## Claims

1. A battery information providing apparatus comprising:
a profile acquisition unit configured to acquire a differential profile based on a capacity and a voltage of a battery; and
a control unit configured to determine a target cycle corresponding to the battery and a target C-rate (current-rate) corresponding to the differential profile, and correct the differential profile based on an overvoltage profile corresponding to the target cycle and the target C-rate, thereby generating a corrected profile.

2. The battery information providing apparatus according to claim 1, wherein the control unit is configured to calculate a difference between the differential profile and the overvoltage profile to generate the corrected profile.

3. The battery information providing apparatus according to claim 1, wherein the overvoltage profile is pre-stored for each of a plurality of charging and discharging cycles and a plurality of C-rates, and
the control unit is configured to select an overvoltage profile corresponding to the target cycle and the target C-rate from a plurality of pre-stored overvoltage profiles.

4. The battery information providing apparatus according to claim 1, wherein the overvoltage profile is preset based on a reference differential profile of a first reference battery for the target cycle and a reference C-rate and a target differential profile of a second reference battery for the target cycle and the target C-rate.

5. The battery information providing apparatus according to claim 4, wherein based on a first target differential profile corresponding to a first target cycle and a second target differential profile corresponding to a second target cycle, a plurality of overvoltage profiles is set to correspond to a plurality of cycles, respectively, included in the first target cycle and the second target cycle.

6. The battery information providing apparatus according to claim 5, wherein the overvoltage profile is set by interpolating a difference between the first target differential profile and the second target differential profile to be proportional to each of the plurality of cycles.

7. The battery information providing apparatus according to claim 4, wherein the overvoltage profile is preset to represent a difference between the reference differential profile and the target differential profile.

8. The battery information providing apparatus according to claim 4, wherein the target C-rate is set to be greater than the reference C-rate.

9. The battery information providing apparatus according to claim 1, wherein the profile acquisition unit is configured to acquire a first differential profile representing a correspondence between the capacity and a differential voltage, and
the control unit is configured to correct the first differential profile based on a first overvoltage profile representing the correspondence between the capacity and the differential voltage.

10. The battery information providing apparatus according to claim 1, wherein the profile acquisition unit is configured to acquire a second differential profile representing a correspondence between the voltage and a differential capacity, and
the control unit is configured to correct the second differential profile based on a second overvoltage profile representing the correspondence between the voltage and the differential capacity.

11. The battery information providing apparatus according to claim 1, wherein the control unit is configured to output the corrected profile to an outside, to provide information about the battery.

12. A battery pack comprising the battery information providing apparatus according to claim 1.

13. A vehicle comprising the battery information providing apparatus according to claim 1.

14. A battery information providing method comprising:
a profile acquisition step of acquiring a differential profile based on a capacity and a voltage of a battery;
a target determination step of determining a target cycle corresponding to the battery and a target C-rate (current-rate) corresponding to the differential profile; and
a corrected profile generation step of correcting the differential profile based on an overvoltage profile corresponding to the target cycle and the target C-rate, thereby generating a corrected profile.

15. A non-transitory computer-readable storage medium having stored therein a program for performing a battery information providing method, the method comprising:
a profile acquisition step of acquiring a differential profile based on a capacity and a voltage of a battery;
a target determination step of determining a target cycle corresponding to the battery and a target C-rate (current-rate) corresponding to the differential profile; and
a corrected profile generation step of correcting the differential profile based on an overvoltage profile corresponding to the target cycle and the target C-rate, thereby generating a corrected profile.
